Europäisches Patentamt

European Patent Office

Office européen des brevets

(11) Publication number: **0 470 607 A2**

# EUROPEAN PATENT APPLICATION

(21) Application number: **91113308.0**

(22) Date of filing: **08.08.91**

(51) Int. Cl.5: **H02M 7/48**

(30) Priority: **09.08.90 JP 209144/90**

(43) Date of publication of application:
**12.02.92 Bulletin 92/07**

(84) Designated Contracting States:
**AT BE CH DE DK ES FR GB GR IT LI LU NL SE**

(71) Applicant: **System Homes Company, Ltd.**
**6-2-3- Maeno-cho**
**Itabashi-ku Tokyo 174(JP)**

(72) Inventor: **Yoshino, Hozo c/o System Homes**
**Company Ltd.,**
**6-2-3 Maeno-cho**
**Itabashi-ku, Tokyo 174(JP)**

(74) Representative: **Vossius & Partner**
**Siebertstrasse 4 P.O. Box 86 07 67**
**W-8000 München 86(DE)**

(54) **Inverter.**

(57) Described is an inverter with a given command frequency (20) for optimizing the efficiency of an induction motor (17). The output ac voltage (16) of the inverter is adjusted, in particular increased, as the load current is modified or increased, respectively.

F I G. 2

The present invention relates to an inverter, and more particularly to an inverter in which output voltage level is adjusted on a real time basis in compliance with load applied to the inverter.

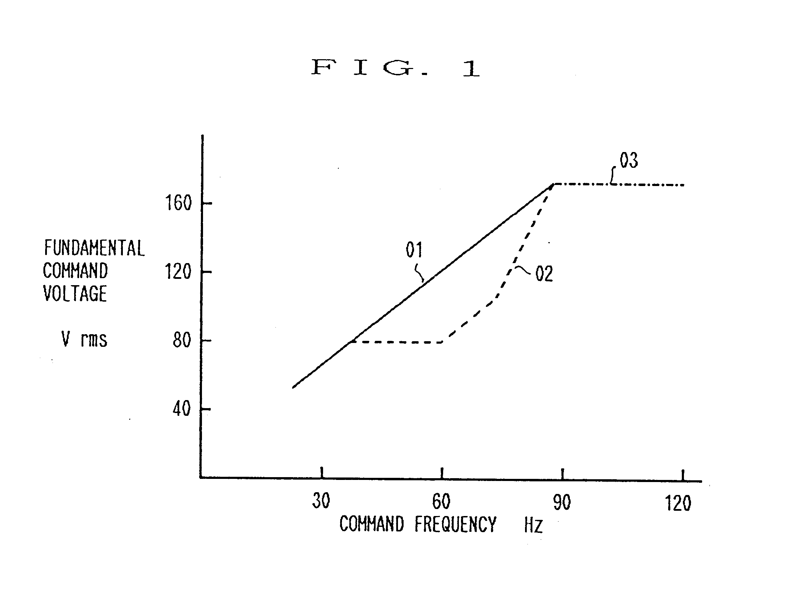

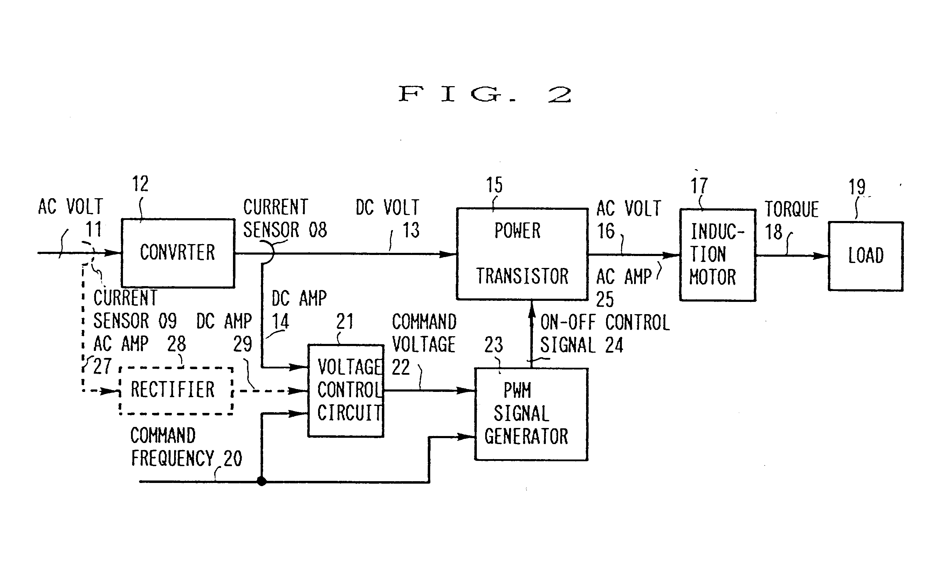

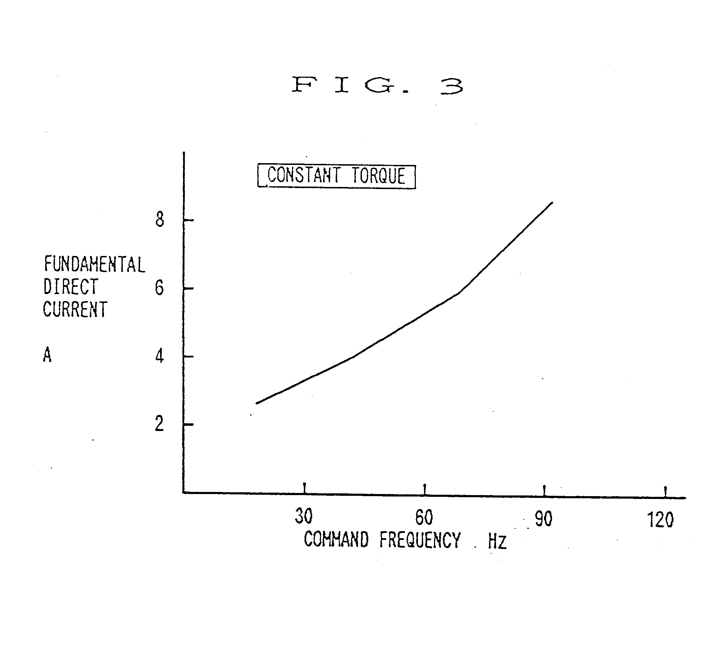

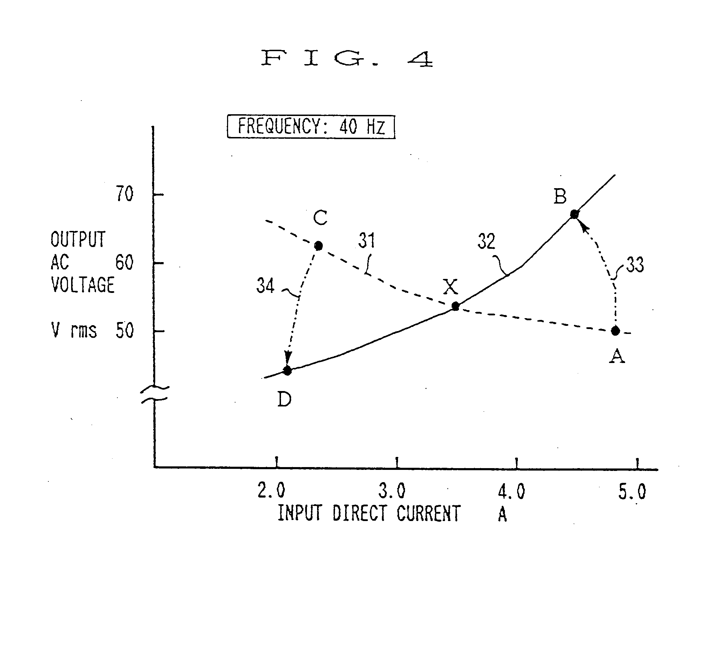

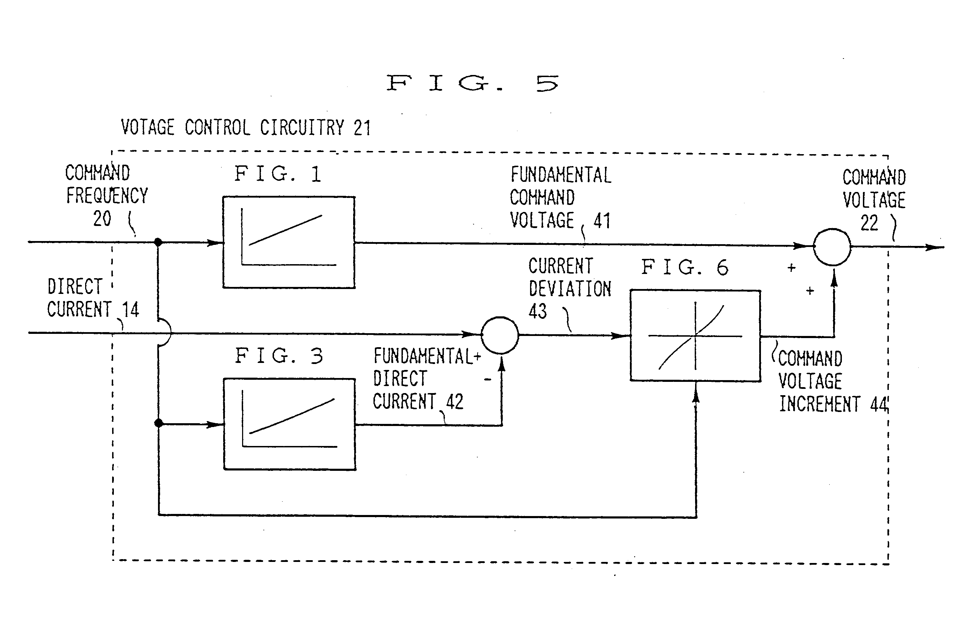

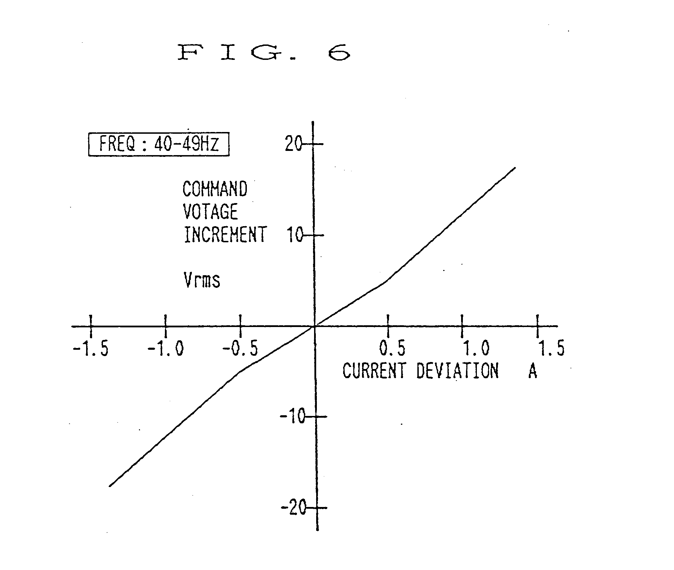

Most of the prior art inverters employ the voltage/frequency (v/f) pattern as a predetermined set so that a fundamental command voltage is determined when a command frequency is selected. Namely, as indicated by Fig.1, a command frequency and fundamental command voltage set is either a constant torque characteristic indicated by a straight line 01, reduced torque characteristic shown by a curved line 02, or a constant power characteristic illustrated by a straight line 03. A desired characteristic or a combination thereof can be selected manually among these characteristics.

When load characteristics are known for a prior art inverter, the most suitable characteristic can be selected for a given load. However, when induction motor is employed as an actuator, desired motor speed and torque vary as a functions of time. Even when induction motor is utilized as quasi-steady power generator, it is often the case that its load is either unknown or varying. As induction motor is being driven off-optimal operating point, input electric energy cannot be converted efficiently to output mechanical energy.

When an alternating current with a constant voltage is applied to stator winding, this becomes an excitation current for induction motor, generating a rotating magnetic field. An eddy current, i.e. load current is then induced on motor rotor. An interaction between the rotating magnetic field and the magnetic field generated by eddy current on the rotor will then generate torque to drive the load coupled to the rotor.

If the magnitude relationship between voltage and current applied to induction motor is unmatched, motor efficiency will be degraded. Namely, if the magnitude of applied voltage is too large compared to the level of the load, iron loss (hysteresis loss of the magnetic circuit) and copper loss (resistance loss of the winding) will increase. These iron and copper losses will increase their magnitude almost proportionately to the circuit current squared. If, on the other hand, the magnitude of applied voltage is too small compared to the level of the load, excitation current through the winding becomes insufficient to generate a necessary rotating magnetic field. To compensate for this insufficiency, the load current will increase drastically resulting in a secondary copper loss, which is almost proportial to the load current squared.

Apparent from the above discussion, there exists an optimum combination of voltage and current applied to induction motor. Since the prior art inverter could not control these two variables independently and simultaneously, there was a room for efficiency improvement.

An object of the present invention is to eliminate above mentioned shortcoming of the prior art inverter and to improve energy efficiency of induction motor. In order to facilitate this scheme, the present embodiment employs continuous sensor measurement of the load level exerted on the motor. For the motor energy efficiency purpose, the command voltage level for the power transistor is adjusted on the basis of measurement made on the instantaneous direct current level of the converter output, or the direct current level corresponding to the input alternating current level of the converter.

Embodiments of carrying out the invention are described in detail below with reference to the accompanying drawings, which illustrate only specific embodiments, in which:-

Fig.1 is a diagram showing the relationship between the fundamental command voltage and the command frequency of the prior art inverter;

Fig.2 is a block diagram showing an embodiment of an inverter according to the present invention;

Fig.3 is a diagram illustrating the relationship between the direct current level and the command frequency under a constant fundamental frequency;

Fig.4 is a diagram comparing the prior art inverter with the present invention illustrating the relationship between the output ac voltage and the input direct current at a constant command frequency;

Fig.5 is a block diagram showing the details of the voltage control circuitry for the present invention;

Fig.6 is a diagram illustrating the relationship between the command voltage increment versus current deviation from the fundamental at a constant frequency.

An embodiment of the present invention is explained by referring to Fig.2. An ac voltage 11 from a power supply is an input to the inverter, which is then converted to a dc voltage 13 by a converter 12 with its direct current 14. The dc voltage 13 is then inverted by a power transistor 15 into an ac voltage 16. The power transistor 15 is driven by an on-off control signal 24.

The ac voltage 16 is then input to an induction motor 17, generating a driving torque on a load 19 which is coupled to the induction motor 17. A command voltage 22 is determined by a voltage control circuitry 21 as a function of the direct current 14 measured by a current sensor 08 and a command frequency 20. The on-off control signal 24 is generated by a PWM signal generator 23 as a function of the command voltage 22 and command frequency 20. The power transistor 15 generates an alternating current with an ac voltage 16.

The alternating current 27 at an input to the converter 12, is measured by a current sensor 09 which is then recified by a rectifier 28 to a direct current output 29. The voltage control circuitry 21 might as well be programmed as a function of the direct current 29 and the command frequency 20 to obtain a command voltage 22.

Functional explanation will be given on the present invention in the following. Assume in Fig.2 that a constant fundamental torque 18 is applied by the load 19 to the induction motor 17 for all command frequencies.

Under the constant fundamental torque 18, the relationship of the command voltage 22 versus command frequency 20 is given as a straight line 01 of Fig.1 as performance optimal locus. As illustrated in Fig.3 for the constant fundamental torque, a fundamental direct current 14 from the converter 12 is given as a function of the command frequency 20. This data may be programmed in a form of a table and prepared beforehand by performing bench test, etc.

The ac voltage 16 from the power transistor 15 is related to the direct current 14 from the converter 12 shown in Fig.4 for the command frequency of 40Hz as an example. The dotted line 31 is a characteristic of the prior art inverter where the setting of the command voltage 22 is fixed independent of the magnitude of the applied load 19. In this case, the level of the ac voltage 16 is lowered as the magnitude of the load 19 or the direct current level 14 is increased due to the increased internal resistance loss of the converter 12 and the power transistor 15. On the other hand, the level of the ac voltage 16 is raised as the magnitude of the load 19 or the direct current level 14 is decreased. The value represented by the letter X" corresponds to the load 19 for the constant fundamental torque. In the case where a nominal direct current level 14 is smaller than the value corresponding to X" in Fig.4, the ac voltage level 16 is too high for the torque 18 applied by the load 19. The excess amount of excitation current will create additional iron and copper losses. This characteristic becomes more significant as the torque 18 applied by the load 19 gets smaller. In the case where a nominal direct current level 14 is larger than the value corresponding to "X" in Fig.4, the ac voltage level 16 is too low for the torque 18 applied by the load 19. An insufficient amount of excitation current in this case will cause the load current to increase such that the secondary copper loss will increase drastically. This characteristic becomes more significant as the torque 18 applied by the load 19 gets larger. It is therefore desirable that the relationship between the direct current 14 and the ac voltage 16 should have a linear relationship as shown by the line 32 in Fig.42 in order for the induction motor 17 to maintain its maximum operating efficiency continuously whatever the torque level 18 of the load 19 might be. For the prior art inverter, the ac voltage level 16 from the power transistor 15 decreases along the dotted line 33 as the direct current 14 increases its magnitude and reaches, for instance, an operating point "A" as indicated. By utilizing the capability of the present invention, the command voltage level 22 can be increased along the locus of the dash and dotted line 33 to an optimal operating point "B". The direct current level 14 for this point will be reduced compared to that at "A", and so is the power input to the inverter. Similarly, the ac voltage level 16 from the power transistor 15 increases along the dotted line 31 as the direct current 14 decreases its magnitude and reaches, for instance, an optimal operating point "C" as indicated.

By utilizing the capability of the present invention, the command voltage level 22 can be decreased along the locus of the dash and dotted line 34 to an optimum operating point "D". The direct current level 14 for this point will be reduced compared to that at "C", and so is the power input to the inverter. In this way, the ac voltage 16 from the power transistor 15 changes its magnitude in accordance with the the direct current level 14 since both levels have a linear relationship with each other. The phase angle between the motor voltage and current stays substantially optimal in this fashon, and the power factor on the load side will be maximized and the induction motor efficiency improves.

The voltage control circuitry 21 in Fig.2 serves to realize such solid line 32 shown in Fig.4, the functional explanation of which will be given in the following.

As illustrated in the block diagram of Fig.5, the voltage control circuitry 21 of the present invention is embodied in a form of software in a microcomputer. There are two tables in the voltage control circuitry 21 for a constant fundamental torque load: One is the relationship between the fundamental command voltage 41 and the command frequency 20 such as the line 01 in Fig.1, and the other is the relationship between the fundamental direct current 42 and the command frequency 20 such as the curved line shown in Fig.3. In controlling the voltage, we must calculate first a deviation 43 of actually measured direct current 14 from the fundamental direct current 42, which corresponds to the point "X" in Fig.4, and then determine the command voltage increment (or decrement) 44 to the direct current deviation 43, and finally add this increment to the fundamental command voltage 44 to obtain the command voltage 22. The command voltage 22 along with the command frequency 20 can now be input to the PWM signal generator 23.

The relationship between the current deviation 43 and the command voltage increment 44 could be tabulated for each frequency band, the graphical form of which is illustrated in Fig.6, and might be memorized within the voltage control circuitry 21.

In the above preferred embodiment, the direct current 14 from the output of the converter 12 is utilized to measure the torque level 18 of the load 19. Instead, the direct current 29 after rectifying the alternating current input to the converter 12 by the rectifier 28 could be used for the same purpose. This is illustrated by the dotted lines in Fig.4. In the preceeding description, the direct current 14 should be replaced with the direct current 29 for the description of this alternate embodiment.

The relationship between the output ac voltage 16 and the input direct current 14 as shown by the solid line 32 in Fig.4 can be realized by the above mentioned embodiment and method, namely, by software in the microcomputer together with the PWM signal generator 23, possibly made of LSI, which can control the frequency and voltage of an inverter independently. Without spending an extra cost on the equipment hardware, induction motor can always be driven at near optimum efficiency. Optimization of load-side power factor contributes to an energy saving.

Because a degree of overload can be reduced by voltage control, design margin for the equipment is reduced and the size of the equipment becomes smaller.

The present embodiment inverter can be thought of as a power source with a negative impedance, as characterized by the solid line 32 in Fig.4.

**Claims**

1. An inverter with a given command frequency (20) for optimizing the efficiency of an induction motor (17), wherein the output ac voltage (16) of the inverter is adjusted on the basis of the load current.

2. An inverter according to claim 1, wherein the output ac voltage (16) is increased as the load current is increased.

3. An inverter as claimed in claim 1 or 2, wherein said inverter comprising:
    (1) a converter (12) to convert an input ac voltage (11) to a dc voltage (13);
    (2) a power transistor (15) to invert said dc voltage (13) to an output ac voltage (16);
    (3) a current sensor (08) to measure a dc current (14) level out of said converter (12) for determining a load (19) level on induction motor (17);

    (4) a voltage control circuitry (21) to calculate a command voltage (22) level as a function of said dc current (14) level and a command frequency (20);
    (5) a PWM signal generator (23) to supply an on-off signal (24) to said power transistor (15) as a function of said command voltage (22) and said command frequency (20) such that real time control is made on said output ac voltage (16) level from said power transistor (15).

4. An inverter as claimed in claim 3, wherein said voltage control circuitry (21) comprises software embedded in a microcomputer.

5. An inverter as claimed in claim 1 or 2, wherein said inverter comprising:
    (1) a converter (12) to convert an input ac voltage (11) to a dc voltage (13);
    (2) a power transistor (15) to invert said dc voltage (13) to an output ac voltage (16);
    (3) a current sensor (09) to measure an input ac current (27) to said converter (12);
    (4) a rectifier (28) to rectify said ac current (27) to a dc current (29) for determining a load (19) level on induction motor (17);
    (5) a voltage control circuitry (21) to calculate a command voltage (22) level as a function of said dc current (14) level and a command frequency (20);
    (6) a PWM signal generator (23) to supply an on-off signal (24) to said power transistor (15) as a function of said command voltage (22) and said command frequency (20) such that real time control is made on said output ac voltage (16) level from said power transistor (15).

6. An inverter as claimed in claim 5, wherein said voltage control circuitry comprises software embedded in a microcomputer.

EP 0 470 607 A2

# F I G .   1

# FIG. 2

EP 0 470 607 A2

F I G. 3

CONSTANT TORQUE

FUNDAMENTAL
DIRECT
CURRENT
A

8

6

4

2

30    60    90    120

COMMAND FREQUENCY . Hz

F I G. 4

EP 0 470 607 A2

FIG. 5

# F I G. 6

FREQ : 40-49HZ

COMMAND
VOTAGE
INCREMENT   10

Vrms

20

-1.5    -1.0    -0.5         0.5    1.0    1.5
                    CURRENT DEVIATION   A

-10

-20